# EUROPEAN PATENT SPECIFICATION

(11) **EP 1 197 292 B1**
(45) Date of publication and mention of the grant of the patent: **17.12.2008**
(21) Application number: 01124458.9
(22) Date of filing: 11.10.2001
(51) Int. Cl.: B24B 37/04, B24B 41/06

(54) **Substrate holding apparatus**
Einrichtung zum Halten eines Substrats
Dispositif de maintien d'un substrat

(30) Priority: 11.10.2000 JP 2000311071; 22.01.2001 JP 2001013899
(43) Date of publication of application: 17.04.2002
(60) Divisional application: 07014804.4
(73) Proprietor: EBARA CORPORATION, Ohta-ku, Tokyo (JP)
(72) Inventor: Togawa, Tetsuji, Chigasaki-shi, Kanagawa-ken (JP); Noji, Ikutaro, Yokohama-shi, Kanagawa-ken (JP); Namiki, Keisuke, Fujisawa-shi, Kanagawa-ken (JP); Yasuda, Hozumi, Fujisawa-shi, Kanagawa-ken (JP); Kojima, Shunichiro, Yokohama-shi, Kanagawa-ken (JP); Sakurai, Kunihiko, Yokohama-shi, Kanagawa-ken (JP); Takada, Nobuyuki, Fujisawa-shi, Kanagawa-ken (JP); Nabeya, Osamu, Chigasaki-shi, Kanagawa-ken (JP); Fukushima, Makoto, Yokohama-shi, Kanagawa-ken (JP); Takayanagi, Hideki, Tokyo (JP)
(74) Representative: Wagner, Karl H.

(56) References cited:
- EP-A- 0 768 148
- WO-A-00/21715

## Description

### BACKGROUND OF THE INVENTION

### Field of the Invention:

The present invention relates to a substrate holding apparatus for holding a substrate to be polished and pressing the substrate against a polishing surface, as per the preamble of claim 1.

### Description of the Related Art:

In a manufacturing process of a semiconductor device, a thin film is formed on a semiconductor device, and then micromachining processes, such as patterning or forming holes, are performed. Thereafter, the above processes are repeated to form thin films on the semiconductor device. Recently, semiconductor devices have become more integrated, and structure of semiconductor elements has become more complicated. In addition, the lumber of layers in multilayer interconnections used for a logical system has been increased. Therefore, irregularities on the surface of the semiconductor device are increased, so that the step height on the surface of the semiconductor device becomes larger.

When the irregularities of the surface of the semiconductor device are increased, the following problems arise. The thickness of a film formed in a portion having a step is relatively small. An open circuit is caused by disconnection of interconnections, or a short circuit is caused by insufficient insulation between the layers. As a result, good products cannot be obtained, and the yield is reduced. Further, even if a semiconductor device initially works normally, reliability of the semiconductor device is lowered after a long-term use. At the time of exposure in a lithography process, if the irradiation surface has irregularities, then a lens unit in an exposure system is locally unfocused. Therefore, if the irregularities of the surface of the semiconductor device are increased, then it is difficult to form a fine pattern on the semiconductor device.

Thus, in the manufacturing process of a semiconductor device, it is increasingly important to planarize the surface of the semiconductor device. The most important one of the planarizing technologies is chemical mechanical polishing (CMP). In the chemical mechanical polishing using a polishing apparatus, while a polishing liquid containing abrasive particles such as silica (SiO₂) therein is supplied onto a polishing surface such as a polishing pad, a substrate such a semiconductor wafer is brought into sliding contact with the polishing surface, so that the substrate is polished.

This type of polishing apparatus comprises a polishing table having a polishing surface constituted by a polishing pad, and a substrate holding apparatus, such as a top ring or a carrier head, for holding a semiconductor wafer. When a semiconductor wafer is polished with this type of polishing apparatus, the semiconductor wafer is held by the substrate holding apparatus and pressed against the polishing table under a predetermined pressure. At this time, the polishing table and the substrate holding apparatus are moved relatively to each other to bring the semiconductor wafer into sliding contact with the polishing surface, so that the surface of the semiconductor wafer is polished to a flat mirror finish.

If a pressing force produced between the semiconductor wafer and the polishing surface of the polishing pad is not uniform over the entire surface of the semiconductor wafer, then the semiconductor wafer is insufficiently or excessively polished depending on the pressing force applied to the semiconductor wafer. Therefore, it has been attempted that a holding surface of the substrate holding apparatus is formed by an elastic membrane of an elastic material such as rubber, and a fluid pressure such as air pressure is applied to the backside surface of the elastic membrane to uniform the pressing force applied to the semiconductor wafer over the entire surface of the semiconductor wafer.

The polishing pad is so elastic that the pressing force applied to the peripheral portion of the semiconductor wafer becomes non-uniform and hence the peripheral portion of the semiconductor wafer is excessively polished to cause edge rounding. In order to prevent such edge rounding, there has been used a substrate holding apparatus in which the semiconductor wafer is held at its peripheral portion by a guide ring or a retainer ring, and the annular portion of the polishing surface that corresponds to the peripheral portion of the semiconductor wafer is pressed by the guide ring or the retainer ring.

The thickness of a thin film formed on the surface of the semiconductor wafer varies from position to position in the radial direction of the semiconductor wafer depending on a film deposition method or the characteristics of a film deposition apparatus. Specifically, the thin film has a film thickness distribution in the radial direction of the semiconductor wafer. When a conventional substrate holding apparatus for uniformly pressing the entire surface of the semiconductor wafer is used for polishing the semiconductor wafer, the entire surface of the semiconductor wafer is polished uniformly. Therefore, the conventional substrate holding apparatus cannot realize the polishing amount distribution that is equal to the film thickness distribution on the surface of the semiconductor wafer, and hence cannot sufficiently cope with the film thickness distribution in the radial direction to cause insufficient or excessive polishing.

As described above, the film thickness distribution on the surface of the semiconductor wafer varies depending on the type of a film deposition method or a film deposition apparatus. Specifically, the position and number of portions having a large film thickness in the radial direction and the difference in thickness between thin film portions and thick film portions vary depending on the type of a film deposition method or a film deposition apparatus. Therefore, a substrate holding apparatus capable of easily coping with various film thickness distributions at low cost has been required rather than a substrate holding apparatus capable of coping with only a specific film thickness distribution.

WO 00/21715 A discloses a semiconductor wafer polishing apparatus with a variable polishing force wafer carrier head and was used as a basis for the preamble of claim 1.

EP-A-0 768 148 discloses a polishing apparatus for polishing a workpiece such as a semiconductor wafer, said polishing apparatus having a turntable with an abrasive cloth mounted on an upper surface thereof, and a top ring for holding a workpiece and pressing the workpiece against the abrasive cloth under a first pressing force to polish the workpiece. A guide ring is vertically movably disposed around the top ring, and pressed against the abrasive cloth under a variable second pressing force. The first and second pressing forces are variable independently of each other, and the second pressing force is determined based on the first pressing force.

### SUMMARY OF THE INVENTION

The present invention has been made in view of the above drawbacks. It is therefore an object of the present invention to provide a substrate holding apparatus capable of polishing a substrate such as a semiconductor wafer in accordance with a thickness distribution of thin film formed on the surface of the substrate, and obtaining uniformity of the film thickness after polishing.

It is another object of the present invention to provide a substrate holding apparatus capable of easily coping with not only a specific film thickness distribution but also various film thickness distributions at low cost.

According to the present invention, there is provided a substrate holding apparatus for holding a substrate to be polished and pressing the substrate against a polishing surface, having the features of claim 1*.*

Preferred embodiments of the present invention may be gathered from the dependent claims.

The above and other objects, features, and advantages of the present invention will be apparent from the following description when taken in conjunction with the accompanying drawings which illustrates preferred embodiments of the present invention by way of example.

### BRIEF DESCRIPTION OF THE DRAWINGS

FIG. 1 is a cross-sectional view showing a whole structure of a polishing apparatus;
FIG. 2 is a vertical cross-sectional view showing a substrate holding apparatus according to the first embodiment of the present invention;
FIG. 3 is a bottom view of the substrate holding apparatus shown in FIG. 2;
FIGS. 4A through 4E are vertical cross-sectional views showing other examples of contact members (central bag and ring tube) in a substrate holding apparatus;
FIG. 5 is a vertical cross-sectional view showing another example of contact members (central bag and ring tube) in a substrate holding apparatus;
FIGS. 6A and 6B are vertical cross-sectional views showing other examples of contact members (central bag and ring tube) in a substrate holding apparatus;
FIG. 7 is a vertical cross-sectional view showing a substrate holding apparatus according to a second embodiment of the present invention;
FIG. 8 is a vertical cross-sectional view showing another example of contact members (central bag and ring tube) in a substrate holding apparatus;
FIG. 9 is a bottom view of the substrate holding apparatus shown in FIG. 8 in such a state that a semiconductor wafer is removed;
FIG. 10 is a bottom view showing another example of contact members (central bag and ring tube) in a substrate holding apparatus;
FIG. 11 is a vertical cross-sectional view showing another example of contact members (central bag and ring tube) in a substrate holding apparatus;
FIG. 12 is a vertical cross-sectional view showing a substrate holding apparatus according to a third embodiment of the present invention;
FIG. 13 is a bottom view of the substrate holding apparatus shown in FIG. 12; and
FIG. 14 is a vertical cross-sectional view showing a substrate holding apparatus according to another embodiment of the present invention.

### DETAILED DESCRIPTION OF THE PREFERRED EMBODIMENTS

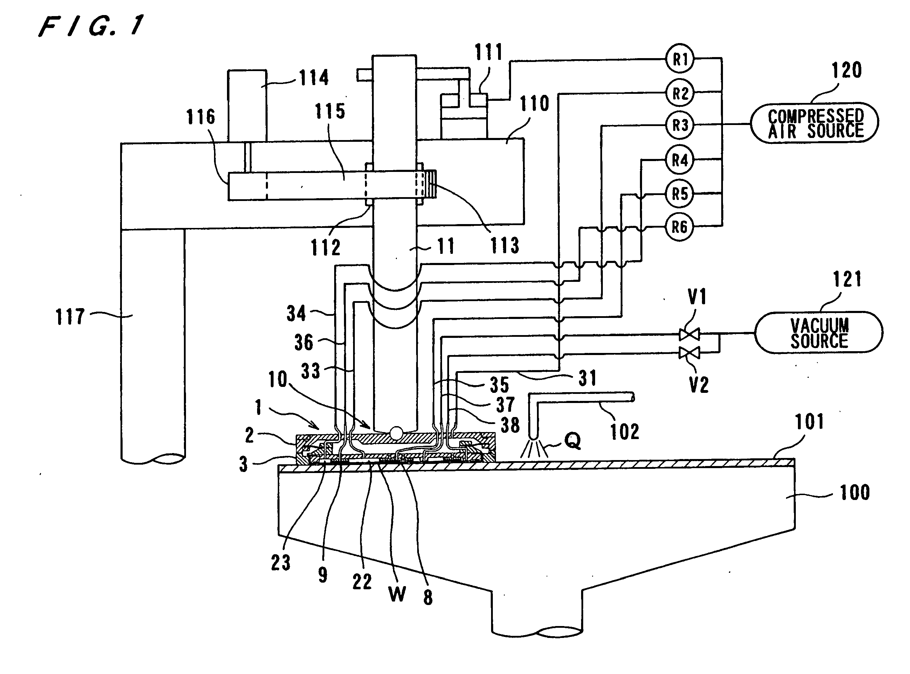

A polishing apparatus according to a first embodiment of the present invention will be described below with reference to FIGS. 1 through 6.

FIG. 1 is a cross-sectional view showing a whole structure of a polishing apparatus having a substrate holding apparatus according to the first embodiment of the present invention. The substrate holding apparatus serves to hold a substrate such as a semiconductor wafer to be polished and to press the substrate against a polishing surface of a polishing table. As shown in FIG. 1, a polishing table 100 is disposed underneath a top ring 1 constituting the substrate holding apparatus according to the present invention and has a polishing pad 101 attached to an upper surface thereof. A polishing liquid supply nozzle 102 is disposed above the polishing table 100 and supplies a polishing liquid Q onto the polishing pad 101 on the polishing table 100.

Various kinds of polishing pads are sold on the market. For example, some of these are SUBA800, IC-1000, and IC-1000/SUBA400 (two-layer cloth) manufactured by Rodel Inc., and Surfin xxx-5 and Surfin 000 manufactured by Fujimi Inc. SUBA800, Surfin xxx-5, and Surfin 000 are non-woven fabrics bonded by urethane resin, and IC-1000 is rigid foam polyurethane (single-layer). Foam polyurethane is porous and has a large number of fine recesses or holes formed in its surface.

The top ring 1 is connected to a top ring drive shaft 11 by a universal joint 10. The top ring drive shaft 11 is coupled to a top ring air cylinder 111 fixed to a top ring head 110. The top ring air cylinder 111 operates to vertically move the top ring drive shaft 11 to thus lift and lower the top ring 1 as a whole. The top ring air cylinder 111 also operates to press a retainer ring 3 fixed to the lower end of a top ring body 2 against the polishing table 100. The top ring air cylinder 111 is connected to a compressed air source (fluid source) 120 via a regulator R1, which regulates the pressure of air supplied to the top ring air cylinder 111 for thereby adjusting a pressing force with which the retainer ring 3 presses the polishing pad 101.

The top ring drive shaft 11 is connected to a rotary sleeve 112 by a key (not shown). The rotary sleeve 112 has a timing pulley 113 fixedly disposed therearound. A top ring motor 114 having a drive shaft is fixed to the upper surface of the top ring head 110. The timing pulley 113 is operatively coupled to a timing pulley 116 mounted on the drive shaft of the top ring motor 114 by a timing belt 115. When the top ring motor 114 is energized, the timing pulley 116, the timing belt 116, and the timing pulley 113 are rotated to rotate the rotary sleeve 112 and the top ring drive shaft 11 in unison with each other, thus rotating the top ring 1. The top ring head 110 is supported on a top ring head shaft 117 fixedly supported on a frame (not shown).

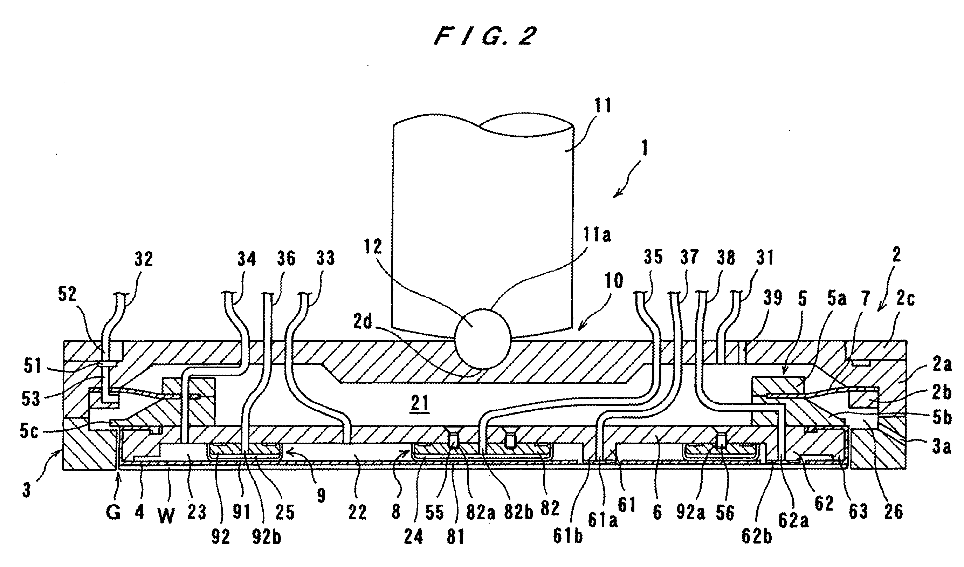

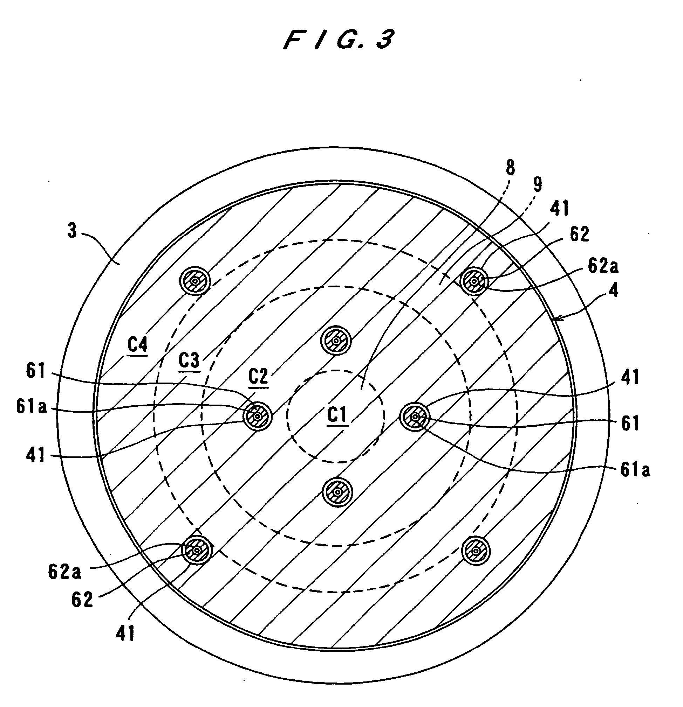

The top ring 1 of the substrate holding apparatus according to the first embodiment of the present invention will be described below. FIG. 2 is a vertical cross-sectional view showing the top ring 1 according to the first embodiment, and FIG. 3 is a bottom view of the top ring 1 shown in FIG. 2.

As shown in FIG. 2, the top ring 1 comprises the top ring body 2 in the form of a cylindrical housing with a storage space defined therein, and the retainer ring 3 fixed to the lower end of the top ring body 2. The top ring body 2 is made of a material having high strength and rigidity, such as metal or ceramics. The retainer ring 3 is made of highly rigid synthetic resin, ceramics, or the like.

The top ring body 2 comprises a cylindrical housing 2a, an annular pressurizing sheet support 2b fitted in the cylindrical housing 2a, and an annular seal 2c fitted over an outer circumferential edge of an upper surface of the cylindrical housing 2a. The retainer ring 3 is fixed to the lower end of the cylindrical housing 2a and has a lower portion projecting radially inwardly. The retainer ring 3 may be integrally formed with the top ring body 2.

The top ring drive shaft 11 is disposed above the center of the cylindrical housing 2a. The top ring body 2 is coupled to the top ring drive shaft 11 by the universal joint 10. The universal joint 10 has a spherical bearing mechanism by which the top ring body 2 and the top ring drive shaft 11 are tiltable with respect to each other, and a rotation transmitting mechanism for transmitting the rotation of the top ring drive shaft 11 to the top ring body 2. The rotation transmitting mechanism and the spherical bearing mechanism transmit pressing and rotating forces from the top ring drive shaft 11 to the top ring body 2 while allowing the top ring body 2 and the top ring drive shaft 11 to be tilted with respect to each other.

The spherical bearing mechanism comprises a spherical recess 11a defined centrally in the lower surface of the top ring drive shaft 11, a spherical recess 2d defined centrally in the upper surface of the housing 2a, and a bearing ball 12 made of a highly hard material such as ceramics and interposed between the spherical recesses 11a and 2d. The rotation transmitting mechanism comprises a drive pin (not shown) fixed to the top ring drive shaft 11, and a driven pin (not shown) fixed to the housing 2a. The drive pin is held in driving engagement with the driven pin while the drive pin and the driven pin are being vertically movable relatively to each other. The rotation of the top ring drive shaft 11 is transmitted to the top ring body 2 through the drive and driven pins. Even when the top ring body 2 is tilted with respect to the top ring drive shaft 11, the drive and driven pins remain in engagement with each other at a moving point of contact, so that the torque of the top ring drive shaft 11 can reliably be transmitted to the top ring body 2.

The top ring body 2 and the retainer ring 3 secured to the top ring body 2 jointly have a space defined therein, which accommodates therein an elastic pad 4 having a lower end surface brought into contact with the upper surface of the semiconductor wafer W held by the top ring 1, an annular holder ring 5, and a disk-shaped chucking plate (support member) 6 for supporting the elastic pad 4. The elastic pad 4 has a radially outer edge clamped between the holder ring 5 and the chucking plate 6 secured to the lower end of the holder ring 5 and extends radially inwardly so as to cover the lower surface of the chucking plate 6, thus forming a space between the elastic pad 4 and the chucking plate 6.

The chucking plate 6 may be made of metal. However, when the thickness of a thin film formed on a surface of a semiconductor wafer is measured by a method using eddy current in such a state that the semiconductor wafer to be polished is held by the top ring, the chucking plate 6 should preferably be made of a non-magnetic material, e.g., an insulating material such as fluororesin or ceramics.

A pressurizing sheet 7, which comprises an elastic membrane, extends between the holder ring 5 and the top ring body 2. The pressurizing sheet 7 is made of a highly strong and durable rubber material such as ethylene propylene rubber (ethylene-propylene terpolymer (EPDM)), polyurethane rubber, silicone rubber, or the like. The pressurizing sheet 7 has a radially outer edge clamped between the housing 2a and the pressurizing sheet support 2b, and a radially inner edge clamped between an upper portion 5a and a stopper 5b of the holder ring 5. The top ring body 2, the chucking plate 6, the holder ring 5, and the pressurizing sheet 7 jointly define a pressure chamber 21 in the top ring body 2. As shown in FIG. 2, a fluid passage 31 comprising tubes and connectors communicates with the pressure chamber 21, which is connected to the compressed air source 120 via a regulator R2 connected to the fluid passage 31.

In the case of a pressurizing sheet 7 made of an elastic material such as rubber, if the pressurizing sheet 7 is clamped between the retainer ring 3 and the top ring body 2, then the pressurizing sheet 7 is elastically deformed as an elastic material, and a desired horizontal surface cannot be maintained on the lower surface of the retainer ring 3. In order to maintain the desired horizontal surface on the lower surface of the retainer ring 3, the pressurizing sheet 7 is clamped between the housing 2a of the top ring body 2 and the pressurizing sheet support 2b provided as a separate member in the present embodiment. The retainer ring 3 may vertically be movable with respect to the top ring body 2, or the retainer ring 3 may have a structure capable of pressing the polishing surface independently of the top ring 2, as disclosed in Japanese laid-open Patent Publication No. 9-168964 and Japanese Patent Application No. 11-294503 (corresponding to European Patent Application No. 00118180.9). In such cases, the pressurizing sheet 7 is not necessarily fixed in the aforementioned manner.

A cleaning liquid passage 51 in the form of an annular groove is defined in the upper surface of the housing 2a near its outer circumferential edge over which the seal 2c is fitted. The cleaning liquid passage 51 communicates with a fluid passage 32 via a through hole 52 formed in the seal 2c, and is supplied with a cleaning liquid (pure water) via the fluid passage 32. A plurality of communication holes 53 are defined in the housing 2a and the pressurizing sheet support 2b in communication with the cleaning liquid passage 51. The communication holes 53 communicate with a small gap G defined between the outer circumferential surface of the elastic pad 4 and the inner circumferential surface of the retainer ring 3. The fluid passage 32 is connected to a cleaning liquid source (not shown) through a rotary joint (not shown).

The space defined between the elastic pad 4 and the chucking plate 6 accommodates therein a central bag 8 as a central contact member brought into contact with the elastic pad 4, and a ring tube 9 as an outer contact member brought into contact with the elastic pad 4. These contact members may be brought into abutment against the elastic pad 4. In the present embodiment, as shown in FIGS. 2 and 3, the central bag 8 having a circular contact surface is disposed centrally on the lower surface of the chucking plate 6, and the ring tube 9 having an annular contact surface is disposed radially outwardly of the central bag 8 in surrounding relation thereto. Specifically, the central bag 8 and the ring tube 9 are spaced at predetermined intervals. Each of the elastic pad 4 and the central bag 8 and the ring tube 9 is made of a highly strong and durable rubber material such as ethylene propylene rubber (ethylene-propylene terpolymer (EPDM)), polyurethane rubber, silicone rubber, or the like.

The space defined between the chucking plate 6 and the elastic pad 4 is divided into a plurality of spaces (second pressure chambers) by the central bag 8 and the ring tube 9. Specifically, a pressure chamber 22 is defined between the central bag 8 and the ring tube 9, and a pressure chamber 23 is defined radially outwardly of the ring tube 9.

The central bag 8 comprises an elastic membrane 81 brought into contact with the upper surface of the elastic pad 4, and a central bag holder (holding member) 82 for detachably holding the elastic membrane 81 in position. The central bag holder 82 has threaded holes 82a defined therein, and is detachably fastened to the center of the lower surface of the chucking plate 6 by screws 55 threaded into the threaded holes 82a. The central bag 8 has a central pressure chamber 24 (first pressure chamber) defined therein by the elastic membrane 81 and the central bag holder 82.

Similarly, the ring tube 9 comprises an elastic membrane 91 brought into contact with the upper surface of the elastic pad 4, and a ring tube holder (holding member) 92 for detachably holding the elastic membrane 91 in position. The ring tube holder 92 has threaded holes 92a defined therein, and is detachably fastened to the lower surface of the chucking plate 6 by screws 56 threaded into the threaded holes 92a. The ring tube 9 has an intermediate pressure chamber 25 (first pressure chamber) defined therein by the elastic membrane 91 and the ring tube holder 92.

Fluid passages 33, 34, 35 and 36 comprising tubes and connectors communicate with the pressure chambers 22, 23, the central pressure chamber 24, and the intermediate pressure chamber 25, respectively. The pressure chambers 22, 23, 24 and 25 are connected to the compressed air source 120 via respective regulators R3, R4, R5 and R6 connected respectively to the fluid passages 33, 34, 35 and 36. The fluid passages 31, 33, 34, 35 and 36 are connected to the respective regulators R2, R3, R4, R5 and R6 through a rotary joint (not shown) mounted on the upper end of the top ring drive shaft 11.

The pressure chamber 21 above the chucking plate 6 and the pressure chambers 22 to 25 are supplied with a pressurized fluid such as pressurized air or atmospheric air or evacuated, via the fluid passages 31, 33, 34, 35 and 36. As shown in FIG. 1, the regulators R2 to R6 connected to the fluid passages 31, 33, 34, 35 and 36 of the pressure chambers 21 to 25 can respectively regulate the pressures of the pressurized fluids supplied to the pressure chambers 21 to 25, for thereby independently controlling the pressures in the pressure chambers 21 to 25 or independently introducing atmospheric air or vacuum into the pressure chambers 21 to 25. Thus, the pressures in the pressure chambers 21 to 25 are independently varied with the regulators R2 to R6, so that the pressing forces, which are pressures per unit area for pressing the semiconductor wafer W against the polishing pad 101, can be adjusted in local areas of the semiconductor wafer W via the elastic pad 4. In some applications, the pressure chambers 21 to 25 may be connected to a vacuum source 121.

In this case, the pressurized fluid or the atmospheric air supplied to the pressure chambers 22 to 25 may independently be controlled in temperature, for thereby directly controlling the temperature of the semiconductor wafer from the backside of the surface to be polished. Particularly, when each of the pressure chambers is independently controlled in temperature, the rate of chemical reaction can be controlled in the chemical polishing process of CMP.

As shown in FIG. 3, a plurality of openings 41 are formed in the elastic pad 4. The chucking plate 6 has radially inner suction portions 61 and radially outer suction portions 62 extended downwardly therefrom. The openings 41 positioned between the central bag 8 and the ring tube 9 allow the inner suction portions 61 to be exposed externally, and the openings 41 positioned outside of the ring tube 9 allow the outer suction portions 62 to be exposed externally. In the present embodiment, the elastic pad 4 has eight openings 41 for allowing the eight suction portions 61, 62 to be exposed.

Each of the inner suction portions 61 has a hole 61a communicating with a fluid passage 37, and each of the outer suction portions 62 has a hole 62a communicating with a fluid passage 38. Thus, the inner suction portion 61 and the outer suction portion 62 are connected to the vacuum source 121 such as a vacuum pump via the respective fluid passages 37, 38 and valves V1, V2. When the suction portions 61, 62 are evacuated by the vacuum source 121 to develop a negative pressure at the lower opening ends of the communicating holes 61a, 62a thereof, a semiconductor wafer W is attracted to the lower ends of the suction portions 61, 62 by the negative pressure. The suction portions 61, 62 have elastic sheets 61b, 62b, such as thin rubber sheets, attached to their lower ends, for thereby elastically contacting and holding the semiconductor wafer W on the lower surfaces thereof.

As shown in FIG. 2, when the semiconductor wafer W is polished, the lower ends of the suction portions 61, 62 are positioned above the lower surface of the elastic pad 4, without projecting downwardly from the lower surface of the elastic pad 4. When the semiconductor wafer W is attracted to the suction portions 61, 62, the lower ends of the suction portions 61, 62 are positioned at the same level as the lower surface of the elastic pad 4.

Since there is the small gap G between the outer circumferential surface of the elastic pad 4 and the inner circumferential surface of the retainer ring 3, the holder ring 5, the chucking plate 6, and the elastic pad 4 attached to the chucking plate 6 can vertically be moved with respect to the top ring body 2 and the retainer ring 3, and hence are of a floating structure with respect to the top ring body 2 and the retainer ring 3. A plurality of teeth 5c project radially outwardly from the outer circumferential edge of the stopper 5b of the holder ring 5. When the teeth 5c engage the upper surface of the radially inwardly projecting portion of the retainer ring 3 upon downward movement of the holder ring 5, the holder ring 5 is limited against any further downward movement.

Operation of the top ring 1 thus constructed will be described below.

When the semiconductor wafer W is to be delivered to the polishing apparatus, the top ring 1 is moved to a position to which the semiconductor wafer W is transferred, and the communicating holes 61a, 62a of the suction portions 61, 62 are evacuated via the fluid passages 37, 38 by the vacuum source 121. The semiconductor wafer W is attracted to the lower ends of the suction portions 61, 62 by suction effect of the communicating holes 61a, 62a. With the semiconductor wafer W attracted to the top ring 1, the top ring 1 is moved to a position above the polishing table 100 having the polishing surface (polishing pad 101) thereon. The retainer ring 3 holds the outer circumferential edge of the semiconductor wafer W so that the semiconductor wafer W is not removed from the top ring 1.

For polishing the lower surface of the semiconductor wafer W, the semiconductor wafer W is thus held on the lower surface of the top ring 1, and the top ring air cylinder 111 connected to the top ring drive shaft 11 is actuated to press the retainer ring 3 fixed to the lower end of the top ring 1 against the polishing surface on the polishing table 100 under a predetermined pressure. Then, the pressurized fluids are respectively supplied to the pressure chambers 22, 23, the central pressure chamber 24, and the intermediate pressure chamber 25 under respective pressures, thereby pressing the semiconductor wafer W against the polishing surface on the polishing table 100. The polishing liquid supply nozzle 102 then supplies the polishing liquid Q onto the polishing pad 101. Thus, the semiconductor wafer W is polished by the polishing pad 101 with the polishing liquid Q being present between the lower surface, to be polished, of the semiconductor wafer W and the polishing pad 101.

The local areas of the semiconductor wafer W that are positioned beneath the pressure chambers 22, 23 are pressed against the polishing pad 101 under the pressures of the pressurized fluids supplied to the pressure chambers 22, 23. The local area of the semiconductor wafer W that is positioned beneath the central pressure chamber 24 is pressed via the elastic membrane 81 of the central bag 8 and the elastic pad 4 against the polishing pad 101 under the pressure of the pressurized fluid supplied to the central pressure chamber 24. The local area of the semiconductor wafer W that is positioned beneath the intermediate pressure chamber 25 is pressed via the elastic membrane 91 of the ring tube 9 and the elastic pad 4 against the polishing pad 101 under the pressure of the pressurized fluid supplied to the intermediate pressure chamber 25.

Therefore, the polishing pressures acting on the respective local areas of the semiconductor wafer W can be adjusted independently by controlling the pressures of the pressurized fluids supplied to each of the pressure chambers 22 to 25. Specifically, each of the regulators R3 to R6 independently regulates the pressure of the pressurized fluid supplied to the pressure chambers 22 to 25 for thereby adjusting the pressing forces applied to press the local areas of the semiconductor wafer W against the polishing pad 101 on the polishing table 100. With the polishing pressures on the respective local areas of the semiconductor wafer W being adjusted independently, the semiconductor wafer W is pressed against the polishing pad 101 on the polishing table 100 that is being rotated. Similarly, the pressure of the pressurized fluid supplied to the top ring air cylinder 111 can be regulated by the regulator R1 to adjust the force with which the retainer ring 3 presses the polishing pad 101. While the semiconductor wafer W is being polished, the force with which the retainer ring 3 presses the polishing pad 101 and the pressing force with which the semiconductor wafer W is pressed against the polishing pad 101 can appropriately be adjusted for thereby applying polishing pressures in a desired pressure distribution to a central area C1, an inner area C2, an intermediate area C3, and a peripheral area C4 of the semiconductor wafer W (see FIG. 3).

The local areas of the semiconductor wafer W that are positioned beneath the pressure chambers 22, 23 are divided into areas to which a pressing force from a fluid is applied via the elastic pad 4, and areas to which the pressure of a pressurized fluid is directly applied, such as areas positioned beneath the openings 41. However, the pressing forces applied to these two areas are equal to each other. When the semiconductor wafer W is polished, the elastic pad 4 is brought into close contact with the upper surface of the semiconductor wafer W near the openings 41, so that the pressurized fluids supplied to the pressure chambers 22, 23 are prevented from flowing out to the exterior.

In this manner, the semiconductor wafer W is divided into the concentric circular and annular areas C1 to C4, which can be pressed under independent pressing forces. The polishing rates of the circular and annular areas C1 to C4, which depend on the pressing forces applied to those areas, can independently be controlled because the pressing forces applied to those areas can independently be controlled. Consequently, even if the thickness of a thin film to be polished on the surface of the semiconductor wafer W suffers radial variations, the thin film on the surface of the semiconductor wafer W can be polished uniformly without being insufficiently or excessively polished. More specifically, even if the thickness of the thin film to be polished on the surface of the semiconductor wafer W differs depending on the radial position on the semiconductor wafer W, the pressure in a pressure chamber positioned over a thicker area of the thin film is made higher than the pressure in a pressure chamber positioned over a thinner area of the thin film, or the pressure in a pressure chamber positioned over a thinner area of the thin film is made lower than the pressure in a pressure chamber positioned over a thicker area of the thin film. In this manner, the pressing force applied to the thicker area of the thin film is made higher than the pressing force applied to the thinner area of the thin film, thereby selectively increasing the polishing rate of the thicker area of the thin film. Consequently, the entire surface of the semiconductor wafer W can be polished exactly to a desired level irrespective of the film thickness distribution obtained at the time the thin film is formed.

Any unwanted edge rounding on the circumferential edge of the semiconductor wafer W can be prevented by controlling the pressing force applied to the retainer ring 3. If the thin film to be polished on the circumferential edge of the semiconductor wafer W has large thickness variations, then the pressing force applied to the retainer ring 3 is intentionally increased or reduced to thus control the polishing rate of the circumferential edge of the semiconductor wafer W. When the pressurized fluids are supplied to the pressure chambers 22 to 25, the chucking plate 6 is subjected to upward forces. In the present embodiment, the pressurized fluid is supplied to the pressure chamber 21 via the fluid passage 31 to prevent the chucking plate 6 from being lifted under the forces from the pressure chambers 22 to 25.

As described above, the pressing force applied by the top ring air cylinder 111 to press the retainer ring 3 against the polishing pad 101 and the pressing forces applied by the pressurized fluids supplied to the pressure chambers 22 to 25 to press the local areas of the semiconductor wafer W against the polishing pad 101 are appropriately adjusted to polish the semiconductor wafer W. When the polishing of the semiconductor wafer W is finished, the semiconductor wafer W is attracted to the lower ends of the suction portions 61, 62 under vacuum in the same manner as described above. At this time, the supply of the pressurized fluids into the pressure chambers 22 to 25 is stopped, and the pressure chambers 22 to 25 are vented to the atmosphere. Accordingly, the lower ends of the suction portions 61, 62 are brought into contact with the semiconductor wafer W. The pressure chamber 21 is vented to the atmosphere or evacuated to develop a negative pressure therein. If the pressure chamber 21 is maintained at a high pressure, then the semiconductor wafer W is strongly pressed against the polishing surface only in areas brought into contact with the suction portions 61, 62. Therefore, it is necessary to decrease the pressure in the pressure chamber 21 immediately. Accordingly, a relief port 39 penetrating through the top ring body 2 may be provided for decreasing the pressure in the pressure chamber 21 immediately, as shown in FIG. 2. In this case, when the pressure chamber 21 is pressurized, it is necessary to continuously supply the pressurized fluid into the pressure chamber 21 via the fluid passage 31. The relief port 39 comprises a check valve (not shown) for preventing an outside air from flowing into the pressure chamber 21 at the time when a negative pressure is developed in the pressure chamber 21.

After the semiconductor wafer W is attracted to the lower ends of the suction portions 61, 62, the entire top ring 1 is moved to a position to which the semiconductor wafer W is to be transferred. Then, a fluid such as compressed air or a mixture of nitrogen and pure water is ejected to the semiconductor wafer W via the communicating holes 61a, 62a of the suction portions 61, 62 to release the semiconductor wafer W from the top ring 1.

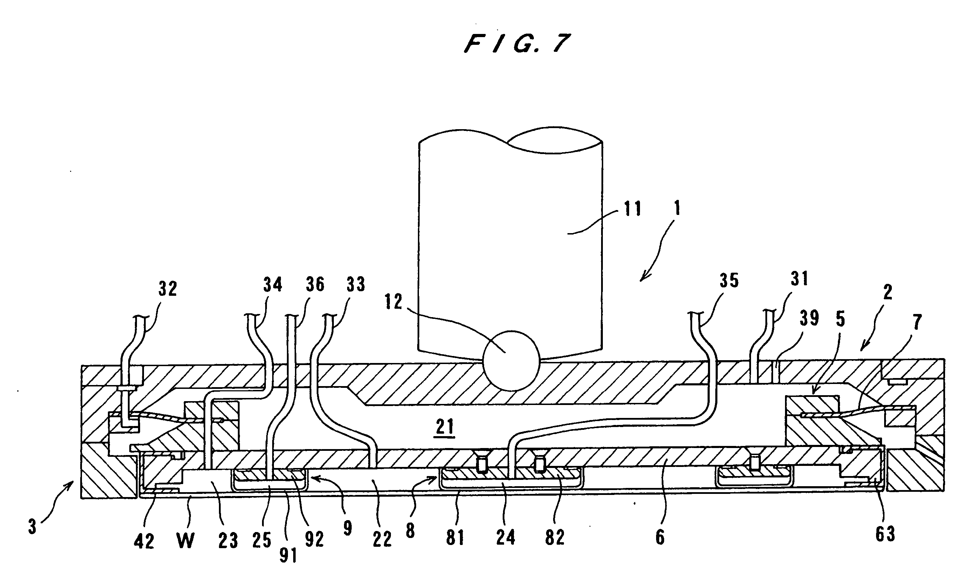

The polishing liquid Q used to polish the semiconductor wafer W tends to flow through the gap G between the outer circumferential surface of the elastic pad 4 and the retainer ring 3. If the polishing liquid Q is firmly deposited in the gap G, then the holder ring 5, the chucking plate 6, and the elastic pad 4 are prevented from smoothly moving vertically with respect to the top ring body 2 and the retainer ring 3. To avoid such a drawback, a cleaning liquid (pure water) is supplied through the fluid passage 32 to the cleaning liquid passage 51. Accordingly, the pure water is supplied via the communication holes 53 to a region above the gap G, thus cleaning members defining the gap G to remove deposits of the polishing liquid Q. The pure water should preferably be supplied after the polished semiconductor wafer W is released and until a next semiconductor wafer to be polished is attracted to the top ring 1. It is also preferable to discharge all the supplied pure water out of the top ring 1 before the next semiconductor wafer is polished, and hence to provide the retainer ring 3 with a plurality of through holes 3a shown in FIG. 7 for discharging the pure water. Furthermore, if a pressure buildup is developed in a space 26 defined between the retainer ring 3, the holder ring 5, and the pressurizing sheet 7, then it acts to prevent the chucking plate 6 from being elevated in the top ring body 2. Therefore, in order to allow the chucking plate 6 to be elevated smoothly in the top ring body 2, the through holes 3a should preferably be provided for equalizing the pressure in the space 26 with the atmospheric pressure.

As described above, according to the present invention, the pressures in the pressure chambers 22, 23, the pressure chamber 24 in the central bag 8, and the pressure chamber 25 in the ring tube 9 are independently controlled to control the pressing forces acting on the semiconductor wafer W.

Further, regions in which a pressing force applied to the semiconductor wafer W is controlled can easily be changed by changing positions or sizes of the central bag 8 and the ring tube 9. Examples of changing the regions in which the pressing force applied to the semiconductor wafer W is controlled will be described below.

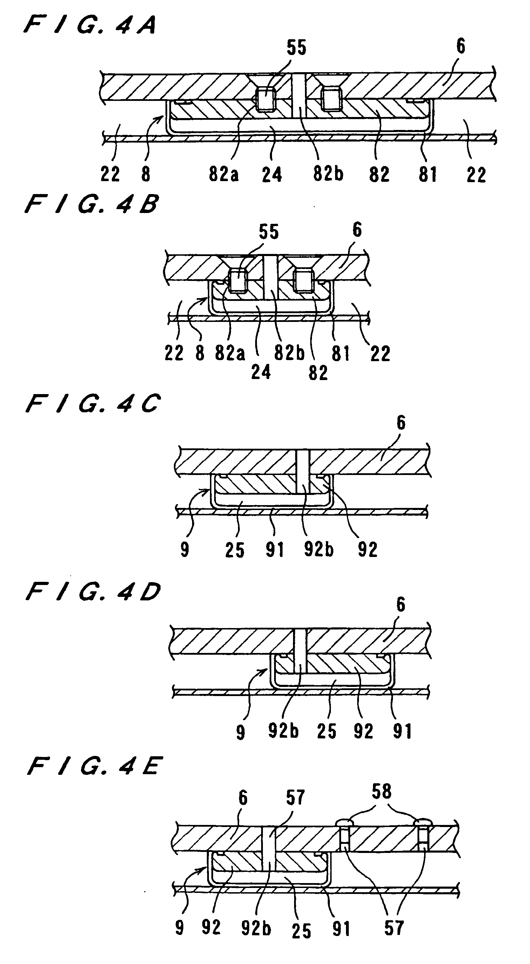

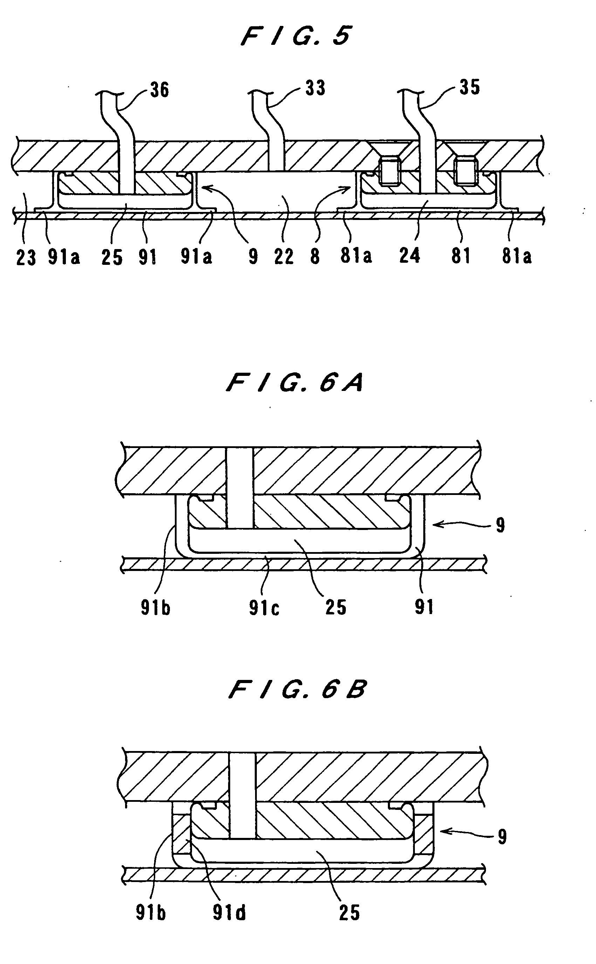

FIGS. 4A through 4E and FIG. 5 are vertical cross-sectional views showing other examples of the contact members (central bag 8 and ring tube 9) in the substrate holding apparatus.

As shown in FIGS. 4A and 4B, the area C1 in which the pressing force applied to the semiconductor wafer is controlled can be changed by another central bag 8 having a different size. In this case, when the size and shape of a hole 82b for allowing the pressure chamber 24 defined in the central bag 8 to communicate with the fluid passage 35, and the size and position of the threaded holes 82a for mounting the central bag holder 82 on the chucking plate 6 are predetermined, the range in which the pressing force applied to the semiconductor wafer is controlled can be changed simply by preparing a central bag holder 82 having a different size. In this case, it is not necessary to modify the chucking plate 6.

As shown in FIGS. 4C and 4D, the width and/or position of the area C3 in which the pressing force applied to the semiconductor wafer is controlled can be changed by another ring tube 9 having a different size and/or shape. Further, as shown in FIG. 4E, a plurality of holes 57 and threaded holes (not shown) may be provided in predetermined radial positions of the chucking plate 6. In this case, the communicating hole 92b is positioned at a position corresponding to one of the communicating holes 57, and the other communicating holes (and threaded holes) are filled with screws 58 for sealing fluids. Thus, the ring tube 9 can flexibly be mounted in the radial direction, so that the region in which the pressing force is controlled can flexibly be changed.

As shown in FIG. 5, a protrusion 81a protruding radially outwardly from the circumferential edge of the elastic membrane 81 may be provided on the lower surface of the central bag 8, and protrusions 91a protruding radially from the circumferential edges of the elastic membrane 91 may be provided on the lower surface of the ring tube 9. The protrusions 81a, 91a are made of the same material as the central bag 8 and the ring tube 9. As described above, when the semiconductor wafer is polished, pressurized fluids are supplied to the pressure chamber 22 positioned between the central bag 8 and the ring tube 9, and the pressure chamber 23 surrounding the ring tube 9. Therefore, the protrusions 81a, 91a are brought into close contact with the elastic pad 4 by the pressurized fluids supplied to the pressure chambers 22, 23. Thus, even if the pressure of the pressurized fluid supplied to the pressure chamber 22 adjacent to the central bag 8 is considerably higher than the pressure of the pressurized fluid supplied to the pressure chamber 24 defined in the central bag 8, the high-pressure fluid adjacent to the central bag 8 is prevented from flowing into the lower portion of the central bag 8. Similarly, even if the pressure of the pressurized fluid supplied to the pressure chamber 22 or 23 adjacent to the ring tube 9 is considerably higher than the pressure of the pressurized fluid supplied to the pressure chamber 25 defined in the ring tube 9, the high-pressure fluid adjacent to the ring tube 9 is prevented from flowing into the lower portion of the ring tube 9. Therefore, the protrusions 81a, 91a can widen the range of pressure control in each of the pressure chambers, for thereby pressing the semiconductor wafer more stably.

The elastic membrane 81, 91 may have a partially different thickness or may partially include an inelastic member. FIG. 6A shows an example in which the elastic membrane 91 of the ring tube 9 has side surfaces 91b thicker than the surface brought into contact with the elastic pad 4. FIG. 6B shows an example in which the elastic membrane 91 of the ring tube 9 partially includes inelastic members 91d in the side surfaces thereof. In these examples, deformation of the side surfaces of the elastic membrane due to the pressure in the pressure chambers can appropriately be limited.

As described above, the distribution of the thin film formed on the surface of the semiconductor wafer varies depending on a deposition method or a deposition apparatus. According to the present invention, a substrate holding apparatus can change the position and size of the pressure chambers for applying the pressing force to the semiconductor wafer simply by change of the central bag 8 and the central bag holder 82, or the ring tube 9 and the ring tube holder 92. Therefore, the position and region in which the pressing force is controlled can easily be changed in accordance with the distribution of the thin film to be polished at low cost. In other words, the substrate holding apparatus can cope with various thickness distributions of the thin film formed on the semiconductor wafer to be polished. The change of the shape and position of the central bag 8 or the ring tube 9 leads to the change of the size of the pressure chamber 22 positioned between the central bag 8 and the ring tube 9, and the pressure chamber 23 surrounding the ring tube 9.

A polishing apparatus according to a second embodiment of the present invention will be described below with reference to FIGS. 7 through 11. FIG. 7 is a vertical cross-sectional view showing a top ring 1 according to the second embodiment. Like parts and components are designated by the same reference numerals and characters as those in the first embodiment.

In the second embodiment, as shown in FIG. 7, the top ring 1 has a seal ring 42 instead of an elastic pad. The seal ring 42 comprises an elastic membrane covering only a lower surface of a chucking plate 6 near its outer circumferential edge. In the second embodiment, neither an inner suction portion (indicated by the reference numeral 61 in FIG. 2) nor an outer suction portion (indicated by the reference numeral 62 in FIG. 2) is provided on the chucking plate 6, for a simple configuration. However, suction portions for attracting a semiconductor wafer may be provided on the chucking plate 6, as with the first embodiment. The seal ring 42 is made of a highly strong and durable rubber material such as ethylene propylene rubber (ethylene-propylene terpolymer (EPDM)), polyurethane rubber, silicone rubber, or the like.

The seal ring 42 is provided in such a state that the lower surface of the seal ring 42 is brought into contact with the upper surface of the semiconductor wafer W. The seal ring 42 has a radially outer edge clamped between the chucking plate 6 and a holder ring 5, as with the elastic pad 4 in the first embodiment. The semiconductor wafer W has a recess defined in an outer edge thereof, which is referred to as a notch or orientation flat, for recognizing or identifying the orientation of the semiconductor wafer. Therefore, the seal ring 42 should preferably extend radially inwardly from the innermost position of the recess such a notch or orientation flat.

A central bag 8 is disposed centrally on the lower surface of the chucking plate 6, and a ring tube 9 is disposed radially outwardly of the central bag 8 in surrounding relation thereto, as with the first embodiment.

In the second embodiment, a semiconductor wafer W to be polished is held by the top ring 1 in such a state that the semiconductor wafer W is brought into contact with the seal ring 42, an elastic membrane 81 of the central bag 8, and an elastic membrane 91 of the ring tube 9. Therefore, the semiconductor wafer W, the chucking plate 6, and the seal ring 42 jointly define a space therebetween, instead of the space defined by the elastic pad and the chucking plate in the first embodiment. This space is divided into a plurality of spaces (second pressure chambers) by the central bag 8 and the ring tube 9. Specifically, a pressure chamber 22 is defined between the central bag 8 and the ring tube 9, and a pressure chamber 23 is defined radially outwardly of the ring tube 9.

Fluid passages 33, 34, 35 and 36 comprising tubes and connectors communicate with the pressure chambers 22, 23, a central pressure chamber (first pressure chamber) 24 defined in the central bag 8, and an intermediate pressure chamber (first pressure chamber) 25 defined in the ring tube 9, respectively. The pressure chambers 22, 23, 24 and 25 are connected to the compressed air source via respective regulators connected respectively to the fluid passages 33, 34, 35 and 36. The regulators connected to the fluid passages 31, 33, 34, 35 and 36 of the pressure chambers 21 to 25 can respectively regulate the pressures of the pressurized fluids supplied to the pressure chambers 21 to 25, for thereby independently controlling the pressures in the pressure chambers 21 to 25 or independently introducing atmospheric air or vacuum into the pressure chambers 21 to 25. Thus, the pressures in the pressure chambers 21 to 25 are independently varied with the regulators, so that the pressing forces can be adjusted in local areas of the semiconductor wafer W. In some applications, the pressure chambers 21 to 25 may be connected to a vacuum source 121.

Operation of the top ring 1 thus constructed will be described below.

When the semiconductor wafer W is to be delivered to the polishing apparatus, the top ring 1 is moved to a position to which the semiconductor wafer W is delivered, and the central bag 8 and the ring tube 9 are supplied with a pressurized fluid under a predetermined pressure for bringing the lower surfaces of the central bag 8 and the ring tube 9 into close contact with the upper surface of the semiconductor wafer W. Thereafter, the pressure chambers 22, 23 are connected to a vacuum source via the fluid passages 33, 34 to develop a negative pressure in the pressure chambers 22, 23 for thereby attracting the semiconductor wafer W under vacuum.

For polishing the lower surface of the semiconductor wafer W, the semiconductor wafer W is thus held on the lower surface of the top ring 1, and the top ring air cylinder 111 connected to the top ring drive shaft 11 is actuated to press the retainer ring 3 fixed to the lower end of the top ring 1 against the polishing surface on the polishing table 100 under a predetermined pressure. Then, the pressurized fluids are respectively supplied to the pressure chambers 22, 23, the central pressure chamber 24, and the intermediate pressure chamber 25 under respective pressures, thereby pressing the semiconductor wafer W against the polishing surface on the polishing table 100. The polishing liquid supply nozzle 102 then supplies the polishing liquid Q onto the polishing pad 101. Thus, the semiconductor wafer W is polished by the polishing pad 101 with the polishing liquid Q being present between the lower surface, to be polished, of the semiconductor wafer W and the polishing pad 101.

The local areas of the semiconductor wafer W that are positioned beneath the pressure chambers 22, 23 are pressed against the polishing pad 101 under the pressures of the pressurized fluids supplied to the pressure chambers 22, 23. The local area of the semiconductor wafer W that is positioned beneath the central pressure chamber 24 is pressed via the elastic membrane 81 of the central bag 8 against the polishing pad 101 under the pressure of the pressurized fluid supplied to the central pressure chamber 24. The local area of the semiconductor wafer W that is positioned beneath the intermediate pressure chamber 25 is pressed via the elastic membrane 91 of the ring tube 9 against the polishing pad 101 under the pressure of the pressurized fluid supplied to the intermediate pressure chamber 25.

Therefore, the polishing pressures acting on the respective local areas of the semiconductor wafer W can be adjusted independently by controlling the pressures of the pressurized fluids supplied to each of the pressure chambers 22 to 25. Thus, the semiconductor wafer W is divided into the concentric circular and annular areas, which can be pressed under independent pressing forces. The polishing rates of the circular and annular areas, which depend on the pressing forces applied to those areas, can independently be controlled because the pressing forces applied to those areas can independently be controlled. Consequently, even if the thickness of a thin film to be polished on the surface of the semiconductor wafer W suffers radial variations, the thin film on the surface of the semiconductor wafer W can be polished uniformly without being insufficiently or excessively polished. More specifically, even if the thickness of the thin film to be polished on the surface of the semiconductor wafer W differs depending on the radial position on the semiconductor wafer W, the pressure in a pressure chamber positioned over a thicker area of the thin film is made higher than the pressure in a pressure chamber positioned over a thinner area of the thin film, or the pressure in a pressure chamber positioned over a thinner area of the thin film is made lower than the pressure in a pressure chamber positioned over a thicker area of the thin film. In this manner, the pressing force applied to the thicker area of the thin film is made higher than the pressing force applied to the thinner area of the thin film, thereby selectively increasing the polishing rate of the thicker area of the thin film. Consequently, the entire surface of the semiconductor wafer W can be polished exactly to a desired level irrespective of the film thickness distribution obtained at the time the thin film is formed.

When the semiconductor wafer W is polished, the seal ring 42 is brought into close contact with a part of the upper surface of the semiconductor wafer for thereby sealing this space. Hence, the pressurized fluid is prevented from flowing out to the exterior of the pressure chamber 23.

When the polishing of the semiconductor wafer W is finished, the semiconductor wafer W is attracted under vacuum in the same manner as described above, and then the pressure chamber 21 is vented to the atmosphere or evacuated to develop a negative pressure therein. After the semiconductor wafer W is attracted, the entire top ring 1 is moved to a position from which the semiconductor wafer W is to be delivered. Then, a fluid such as compressed air or a mixture of nitrogen and pure water is ejected to the semiconductor wafer W via the fluid passages 33, 34 to release the semiconductor wafer W from the top ring 1. If the elastic membrane 81 of the central bag 8 and the elastic membrane 91 of the ring tube 9 have through holes defined in their lower surfaces, then since downward forces are applied to the semiconductor wafer W by the fluid flowing through these through holes, the semiconductor wafer W can be smoothly released from the top ring 1. After the semiconductor wafer W is released from the top ring 1, most of the lower surface of the top ring 1 is exposed. Therefore, the lower surface of the top ring 1 can be cleaned relatively easily after the semiconductor wafer W is polished and released.

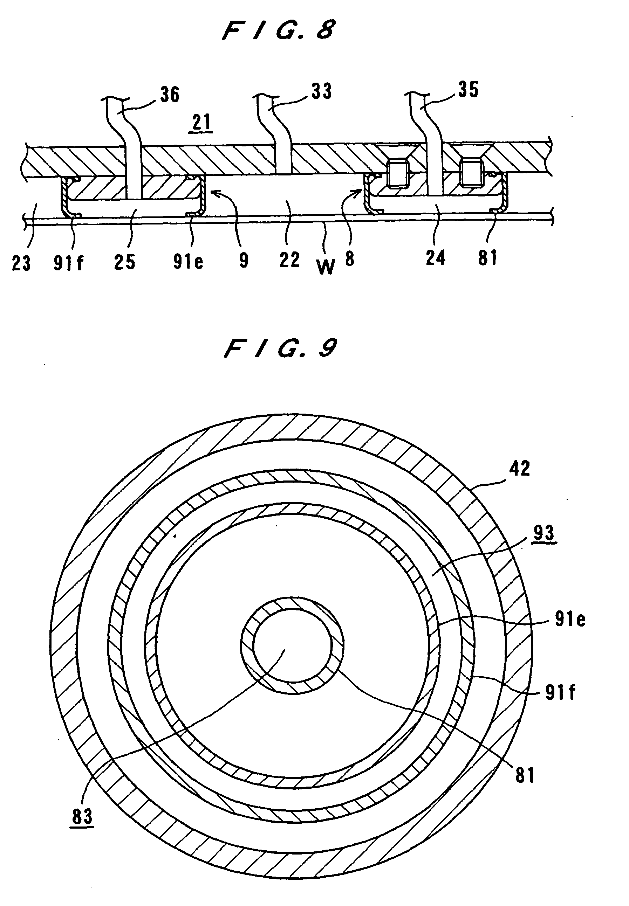

Other Examples of the central bag 8 and the ring tube 9 in the substrate holding apparatus according to the present invention will be described below. FIG. 8 is a vertical cross-sectional view showing another example of the present invention, and FIG. 9 is a bottom view of FIG. 8 in such a state that a semiconductor wafer W is removed.

In this example, as shown in FIGS. 8 and 9, a central bag 8 has an elastic membrane 81 only at the outer circumferential edge of the central bag 8, and a circular hole (communicating portion) 83 is formed in the lower surface of the elastic membrane 81 of the central bag 8. A ring tube 9 has two elastic membranes, i.e., a radially inner elastic membrane 91e and a radially outer elastic membrane 91f, and an annular groove (communicating portion) 93 is formed between the inner elastic membrane 91e and the outer elastic membrane 91f. Pressurized fluids supplied to the central pressure chamber 24 and the intermediate pressure chamber 25 contact the upper surface, which is a contact surface, of the semiconductor wafer W.

When the pressurized fluids supplied to the central pressure chamber 24 and the intermediate pressure chamber 25 are controlled in temperature and the temperature of the semiconductor wafer W is controlled from the backside of the surface to be polished, as described above, the communicating portions 83, 93 formed in the lower surfaces of the elastic membranes of the central bag 8 and the ring tube 9 can increase the area in which the pressurized fluid controlled in temperature is brought into contact with the semiconductor wafer W. Therefore, controllability in temperature of the semiconductor wafer W can be improved. Further, when the polishing of the semiconductor wafer W is finished and the semiconductor wafer W is released, the central pressure chamber 24 and the intermediate pressure chamber 25 are respectively opened to the outside air via the circular hole 83 and the annular groove 93. Thus, fluids supplied into the central pressure chamber 24 and the intermediate pressure chamber 25 are prevented from remaining in the central pressure chamber 24 and the intermediate pressure chamber 25. Therefore, even when semiconductor wafers W are continuously polished, controllability in temperature of the semiconductor wafer W can be maintained.

When the semiconductor wafer W is polished, the pressurized fluids are supplied to the central pressure chamber 24 and the intermediate pressure chamber 25. Therefore, the lower surface of the elastic membrane 81 of the central bag 8 and the lower surface of the inner and outer elastic membranes 91e, 91f of the ring tube 9 are pressed against the upper surface, which is the contact surface, of the semiconductor wafer W. Accordingly, even though the circular hole 83 and the annular groove 93 are formed in the elastic membranes, the pressurized fluids supplied to the central pressure chamber 24 and the intermediate pressure chamber 25 are prevented from flowing out to the exterior.

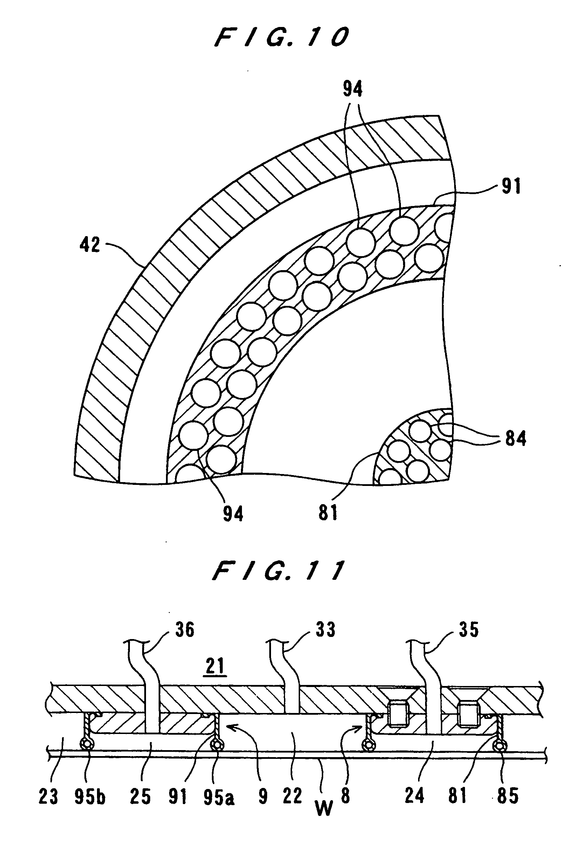

In the example shown in FIGS. 8 and 9, a force that causes the circular hole 83 to expand outwardly acts on the elastic membrane 81 of the central bag 8 due to the pressurized fluid supplied to the central pressure chamber 24. A force that causes the annular groove 93 to expand outwardly acts on the elastic membranes 91e, 91f of the ring tube 9 due to the pressurized fluid supplied to the intermediate pressure chamber 25. In order to disperse these forces, a plurality of circular holes (communicating portions) 84, 94 may be provided on the lower surface of the elastic membrane 81, 91 of the central bag 8 and the ring tube 9, as shown in FIG. 10.

As shown in FIG. 11, an annular contacting portion 85 having a sealed fluid therein may be provided at the lower end of the elastic membrane 81 of the central bag 8. Further, an (inner) annular contacting portion 95a and an (outer) annular contacting portion 95b each having a sealed fluid therein may be provided at the lower end of the elastic membrane 91 of the ring tube 9. In this case, the contacting portions 85, 95a, 95b are pressed against the semiconductor wafer W by a pressurized fluid supplied to the pressure chamber 21, and hence the pressure chambers 22, 23, the central pressure chamber 24, and the intermediate pressure chamber 25 are respectively sealed with the contacting portions 85, 95a, 95b. At this time, the contacting portions 85, 95a, 95b pressed against the semiconductor wafer W are deformed to increase the area in which the contacting portions 85, 95a, 95b are brought into contact with the semiconductor wafer W, so that the force applied to the semiconductor wafer W becomes larger. However, adjustment of the pressure in the pressure chamber 21 can prevent an excessive force from being applied to the semiconductor wafer W by the contacting portions 85, 95a and 95b. The examples shown in FIGS. 8 through 11 can be applied to the first embodiment.

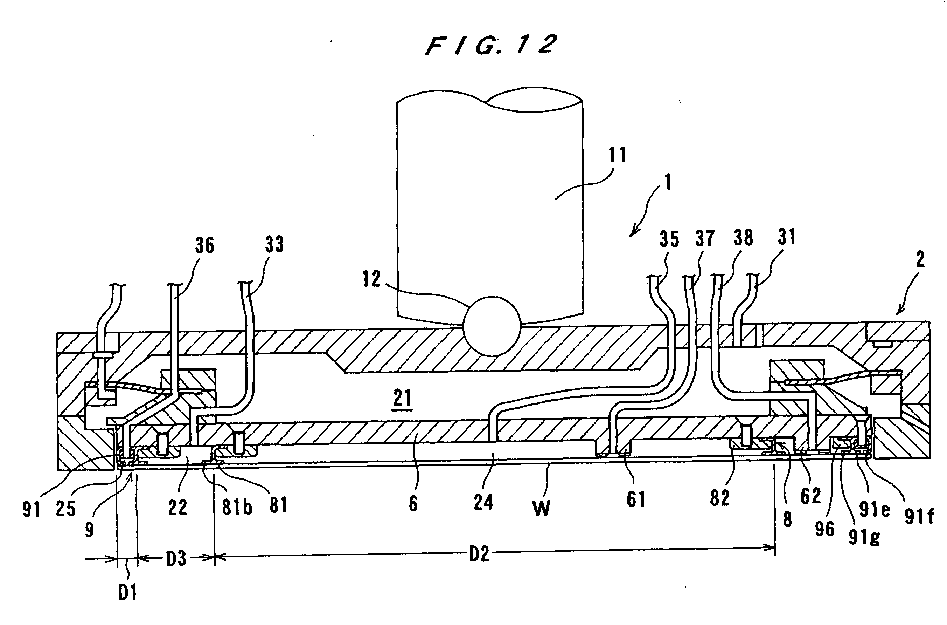

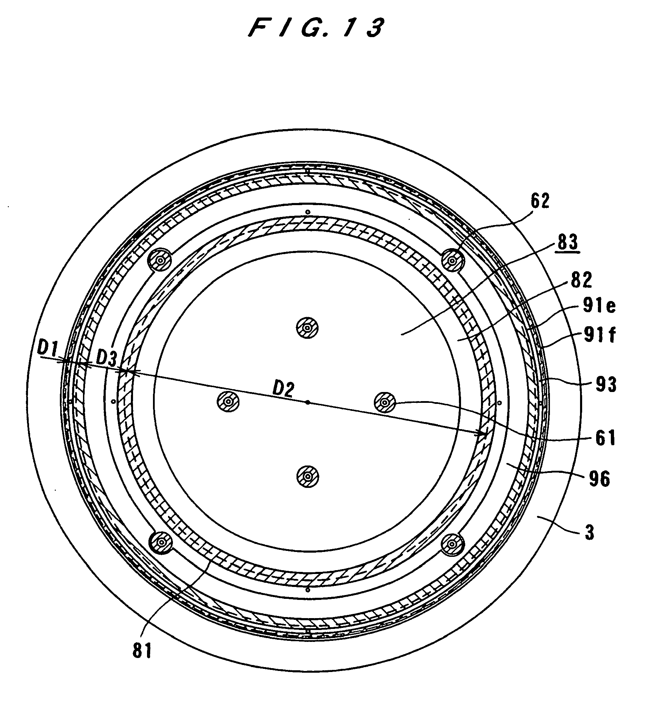

A polishing apparatus according to a third embodiment of the present invention will be described below with reference to FIGS. 12 and 13. FIG. 12 is a vertical cross-sectional view showing a top ring 1 according to the third embodiment, and FIG. 13 is a bottom view showing the top ring 1 of the FIG. 12 in such a state that a semiconductor wafer W is removed. Like parts and components are designated by the same reference numerals and characters as those in the second embodiment.

In the third embodiment, as shown in FIG. 12, the top ring 1 has no elastic pad and no seal ring. A central bag 8 has an annular central bag holder 82, and an annular elastic membrane 81 is held at the outer circumferential edge of the central bag holder 82. A circular hole 83 is formed in the lower surface of the elastic membrane 81 of the central bag 8, as with the example shown in FIGS. 8 and 9.

The ring tube 9 is mounted at a position corresponding to the outer peripheral portion of the semiconductor wafer W. The ring tube 9 has an inner elastic membrane 91e and an outer elastic membrane 91f, and an annular groove 93 is formed between the inner elastic membrane 91e and the outer elastic membrane 91f, as with the example shown in FIGS. 8 and 9. An annular auxiliary holder 96 is disposed inside of a ring tube holder. The inner elastic membrane 91e of the ring tube 9 has a protrusion protruding radially inwardly from the upper end thereof. The protrusion is held by the auxiliary holder 96, so that the inner elastic membrane 91e is held securely.

The elastic membrane 81 of the central bag 8 has a protrusion 81b protruding radially outwardly from the lower circumferential edge thereof. The inner elastic membrane 91e of the ring tube 9 has a protrusion 91g protruding radially inwardly from the lower circumferential edge thereof. As described in the example shown in FIG. 5, these protrusions can widen the range of pressure control, for thereby pressing the semiconductor wafer W against the polishing surface more stably.

The chucking plate 6 has inner suction portions 61 and outer suction portions 62 for attracting a semiconductor wafer W thereto, as with the first embodiment. The inner suction portions 61 are disposed inside of the central bag 8, and the outer suction portions 62 are disposed between the central bag 8 and the ring tube 9.

In the present embodiment, the semiconductor wafer W to be polished is held by the top ring 1 in such a state that the semiconductor wafer W is brought into contact with the elastic membranes 81, 91e, 91f of the central bag 8 and the ring tube 9. Therefore, the central bag 8 and the ring tube 9 jointly define a pressure chamber 22 between the semiconductor wafer W and the chucking plate 6. As described above, the ring tube 9 is mounted at a position corresponding to the outer peripheral portion of the semiconductor wafer W, and a pressure chamber (indicated by the reference numeral 23 in FIG. 7) is not defined outside of the ring tube 9.

Fluid passages 31, 33, 35 and 36 comprising tubes and connectors communicate with a pressure chambers 21 defined above the chucking plate 6, the pressure chamber 22, a central pressure chamber (first pressure chamber) 24 defined in the central bag 8, and an intermediate pressure chamber (first pressure chamber) 25 defined in the ring tube 9, respectively. The pressure chambers 21, 22, 24 and 25 are connected to a compressed air source via respective regulators connected respectively to the fluid passages 31, 33, 35 and 36. The regulators connected to the fluid passages 31, 33, 35 and 36 of the pressure chambers 21, 22, 24 and 25 can respectively regulate the pressures of the pressurized fluids supplied to the pressure chambers 21, 22, 24 and 25, for thereby independently controlling the pressures in the pressure chambers 21, 22, 24 and 25 or independently introducing atmospheric air or vacuum into the pressure chambers 21, 22, 24 and 25. Thus, the pressures in the pressure chambers 21, 22, 24 and 25 are independently varied with the regulators, so that the pressing forces can be adjusted in local areas of the semiconductor wafer W.

When the semiconductor wafer W is polished, it is difficult to uniformly polish the peripheral portion of the semiconductor wafer W, because of elastic deformation of the polishing pad or the like or entry of a polishing liquid into a space between the polishing surface and the semiconductor wafer W, regardless of the thickness distribution of a thin film formed on the surface of the semiconductor wafer W to be polished. In the present embodiment, the ring tube 9 is mounted at a position corresponding to the outer peripheral portion of the semiconductor wafer W. Further, the width D1 of the ring tube 9 is narrow, and the diameter D2 of the central bag 8 is large. Hence, the pressing force applied to the peripheral portion of the semiconductor wafer W is controlled to uniformly polish the peripheral portion of the semiconductor wafer W. Specifically, the ring tube 9 should preferably have a width of 10 mm or less, more preferably 5 mm or less. The distance D3 between the central bag 8 and the ring tube 9 should preferably be in the range of 20 to 25 mm in the case of a semiconductor wafer having a diameter of 200 mm, and in the range of 25 to 30 mm in the case of a semiconductor wafer having a diameter of 300 mm.

While the present invention has been described in detail with reference to the preferred embodiments thereof, it would be apparent to those skilled in the art that many modifications and variations may be made therein without departing from the scope of the claims.

In the embodiments described above, the fluid passages 31, 33, 34, 35 and 36 are provided as separate passages. However, the arrangement of the fluid passages and the pressure chambers may be modified in accordance with the magnitude of the pressing force to be applied to the semiconductor wafer W and the position to which the pressing force is applied. For example, these passages may be joined to each other, or the pressure chambers may be connected to each other.

The pressure chambers 22, 23 may be connected to the pressure chamber 21 to form one pressure chamber, without the fluid passage 33 communicating with the pressure chamber 22 and the fluid passage 34 communicating with the pressure chamber 23. In this case, the pressures in the pressure chambers 21, 22, 23 are controlled at an equal pressure by a pressurized fluid supplied via the fluid passage 31. If it is not necessary to provide a pressure difference between the pressure chamber 22 and the pressure chamber 23, and the pressures in the central pressure chamber 24 and the intermediate pressure chamber 25 are not larger than the pressures in the pressure chambers 21, 22, 23, then the above arrangement can be adopted to dispense with the fluid passages 33, 34, for thereby decreasing the number of the fluid passages and simplifying the fluid passages.

When the inner suction portions 61 and the outer suction portions 62 are provided on the chucking plate 6, as in the first and third embodiments, not only a vacuum is created in the fluid passages 37, 38 communicating with the suction portions 61, 62, but also pressurized fluids may be supplied to the fluid passages 37, 38. In this case, suction of the semiconductor wafer in the suction portions 61, 62 and supply of the pressurized fluids to the pressure chambers 22, 23 can be performed with one respective passage. Hence, it is not necessary to provide two fluid passages, i.e., the fluid passages 33, 34, for thereby decreasing the number of the fluid passages and simplifying the fluid passages.

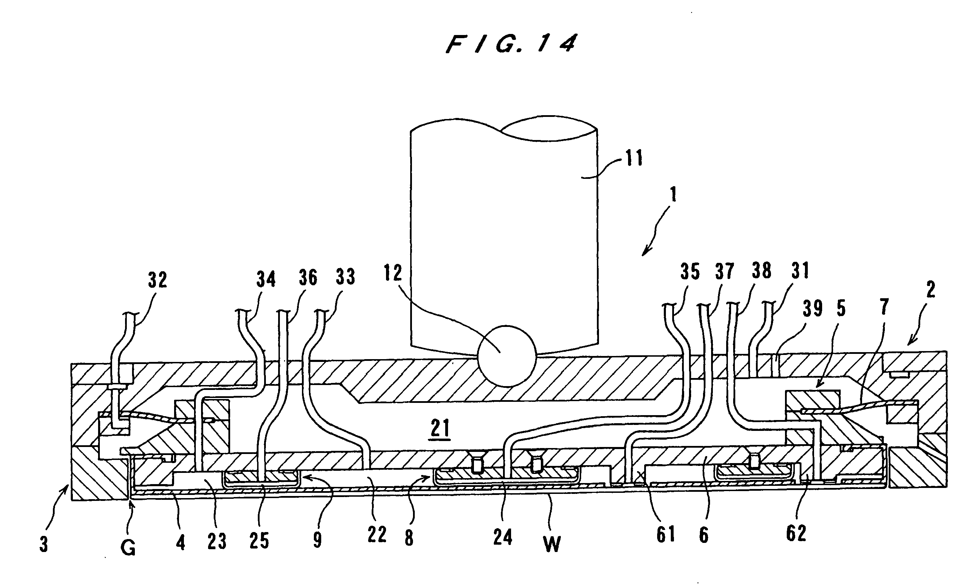

In the first and second embodiments, the chucking plate 6 has a protuberance 63 projecting downwardly from the outer circumferential edge thereof for maintaining the shape of the lower peripheral portion of the elastic membrane 4 or the seal ring 42 (see FIGS. 2 and 7). However, if it is not necessary to maintain the shape of the elastic membrane 4 or the seal ring 42 because of its material or the like, then the chucking plate 6 does not need to have such a protuberance. FIG. 14 is a vertical cross-sectional view showing a top ring 1 in which the chucking plate 6 has no protuberance 63 in the first embodiment. In this case, the semiconductor wafer W can uniformly be pressed from the central portion thereof to the outer peripheral portion thereof. Further, the semiconductor wafer can easily follow the large waviness or undulation on the polishing surface.

In the embodiments described above, the polishing surface is constituted by the polishing pad. However, the polishing surface is not limited to this. For example, the polishing surface may be constituted by a fixed abrasive. The fixed abrasive is formed into a flat plate comprising abrasive particles fixed by a binder. With the fixed abrasive, the polishing process is performed by the abrasive particles self-generated from the fixed abrasive. The fixed abrasive comprises abrasive particles, a binder, and pores. For example, cerium dioxide (CeO₂) having an average particle diameter of 0.5 µm is used as an abrasive particle, and epoxy resin is used as a binder. Such a fixed abrasive forms a harder polishing surface. The fixed abrasive includes a fixed abrasive pad having a two-layer structure formed by a thin layer of a fixed abrasive and an elastic polishing pad attached to the layer of the fixed abrasive. IC-1000 described above may be used for another hard polishing surface.

As described above, pressures in a first pressure chambers and a second pressure chamber can be independently controlled. Therefore, a pressing force applied to a thicker area of a thin film can be made higher than a pressing force applied to a thinner area of the thin film, thereby selectively increasing the polishing rate of the thicker area of the thin film. Consequently, an entire surface of a substrate can be polished exactly to a desired level irrespective of the film thickness distribution obtained at the time the thin film is formed.

Further, a contact member comprises a holding member for detachably holding an elastic membrane, or the holding member of the contact member is detachably mounted on a support member. Hence, the elastic membrane or the contact member can easily be replaced with another one. Specifically, the position and size of the first pressure chamber and the second pressure chamber can be changed simply by change of the elastic membrane or the contact member. Therefore, a substrate holding apparatus according to the present invention can easily cope with various thickness distributions of a thin film formed on the substrate to be polished at a low cost.

In a substrate holding apparatus comprising a seal ring, the lower surface of the support member is not covered after the semiconductor wafer is released. Therefore, a large part of the lower surface of the support member is exposed after the semiconductor wafer is released, so that the substrate holding apparatus can easily be cleaned after the polishing process.

Furthermore, a protrusion radially protruding from a circumferential edge of the elastic membrane of the contact member is provided on the lower surface of the elastic membrane. Therefore, the protrusion is brought into close contact with an elastic pad or a substrate by a pressurized fluid supplied to the second pressure chamber to prevent the pressurized fluid from flowing into the lower portion of the contact member. Hence, the range of pressure control can be widened to press the substrate against the polishing surface more stably.

Although certain preferred embodiments of the present invention have been shown and described in detail, it should be understood that various changes and modifications may be made therein without departing from the scope of the appended claims.

## Claims

1. A substrate holding apparatus for holding a substrate to be polished and pressing said substrate against a polishing surface, said substrate holding apparatus comprising:
a top ring body (2) for holding a substrate (W);
a support member (6) having a contact member (8, 9) mounted on a lower surface thereof, said contact member being disposed in a space formed by said substrate (W) and said support member and having an elastic membrane (4) brought into contact with said substrate;
a first pressure chamber (24, 25) defined in said contact member (8, 9);
a second pressure chamber (22, 23) defined outside of said contact member (8, 9);
a fluid source (120) for independently supplying a fluid into or creating a vacuum in said first pressure chamber (24, 25) and said second pressure chamber (22, 23); and
a retainer ring (3) fixed to or integrally formed with said top ring body (2) for holding a peripheral portion of said substrate (W);
**characterized in that**
said top ring body (2) comprises a cleaning liquid passage (51) defined therein for supplying a cleaning liquid (Q) into a gap (G) defined between an outer circumferential surface of said substrate (W) and said retainer ring (3).

2. A substrate holding apparatus according to claim 1, wherein said fluid source (120) supplies a fluid controlled in temperature into said first pressure chamber and said second pressure chamber, respectively.

3. A substrate holding apparatus according to claim 1, wherein a communicating portion (83, 93) for allowing said fluid supplied to said first pressure chamber (24, 25) to contact a contact surface of said substrate is formed in the lower surface of said elastic membrane (4) of said contact member (8, 9).

4. A substrate holding apparatus according to claim 1, wherein said contact member (8, 9) comprises a holding member (82, 92) for detachably holding said elastic membrane (4).

5. A substrate holding apparatus according to claim 4, wherein said holding member (82, 92) of said contact member (8, 9) is detachably mounted on said support member (6).

6. A substrate holding apparatus according to any of the preceding claims, wherein said contact member (8, 9) includes a central contact member (8) disposed at a position corresponding to a central portion of said substrate (W), and an outer contact member (9) disposed outside of said central contact member (8).

7. A substrate holding apparatus according to claim 6, wherein said outer contact member (9) is mounted at a position corresponding to an outer peripheral portion of said substrate (W).

8. A substrate holding apparatus according to any of the preceding claims, wherein said support member (6) is made of an insulating material.

## Patentansprüche

1. Substrathaltevorrichtung zum Halten eines zu polierenden Substrats und zum Drücken des Substrats gegen eine Polieroberfläche, wobei die Substrathaltevorrichtung Folgendes aufweist:
einen Topringkörper (2) zum Halten eines Substrats (W);
ein Tragglied (6) mit einem Kontaktglied (8, 9), das an einer Unterseite davon angebracht ist, wobei das Kontaktglied in einem Raum angeordnet ist, der durch das Substrat (W) und das Tragglied gebildet wird, und das eine elastische Membran (4) aufweist, die in Kontakt mit dem Substrat gebracht wird;
eine erste Druckkammer (24, 25), die in dem Kontaktglied (8, 9) definiert ist;
eine zweite Druckkammer (22, 23), die außerhalb des Kontaktglieds (8, 9) definiert ist;
eine Fluidquelle (120) zum unabhängigen Liefern eines Fluids in die erste Druckkammer (24, 25) und die zweite Druckkammer (22, 23) oder zum Erzeugen eines Vakuums darin; und
einen Haltering (3), der an dem Topringkörper (2) befestigt oder integral damit ausgebildet ist, zum Halten eines Umfangsteils des Substrats (W); **dadurch gekennzeichnet, dass** der Topringkörper (2) einen Reinigungsflüssigkeitsdurchlass (51) darin definiert aufweist zum Liefern einer Reinigungsflüssigkeit (Q) in einen Spalt (G) der zwischen einer Außenumfangsfläche des Substrats (W) und dem Haltering (3) definiert ist.

2. Substrathaltevorrichtung nach Anspruch 1, wobei die Fluidquelle (120) ein hinsichtlich seiner Temperatur gesteuertes Fluid in die erste Druckkammer bzw. die zweite Druckkammer liefert.

3. Substrathaltevorrichtung nach Anspruch 1, wobei ein Verbindungsteil (83, 93) vorgesehen ist zum Erlauben, dass das Fluid das zu der ersten Druckkammer (24, 25) geliefert wurde eine Kontaktoberfläche des Substrats kontaktiert, wobei der Verbindungsteil in der Unterseite der elastischen Membran (4) des Kontaktglieds (8, 9) ausgebildet ist.

4. Substrathaltevorrichtung nach Anspruch 1, wobei das Kontaktglied (8, 9) ein Halteglied (82, 92) aufweist zum lösbaren Halten der elastischen Membrane (4).

5. Substrathaltevorrichtung nach Anspruch 4, wobei das Halteglied (82, 92) des Kontaktglieds (8, 9) lösbar an dem Tragglied (6) angebracht ist.

6. Substrathaltevorrichtung nach einem der vorhergehenden Ansprüche, wobei das Kontaktglied (8, 9) ein mittleres Kontaktglied (8) aufweist, das an einer Position angeordnet ist, die einem Mittelteil des Substrats (W) entspricht, und ein äußeres Kontaktglied (9), das außerhalb des mittleren Kontaktglieds (8) angeordnet ist.

7. Substrathaltevorrichtung nach Anspruch 6, wobei das äußere Kontaktglied (9) an einer Position angebracht ist, die einem äußeren Umfangsteil des Substrats (W) entspricht.

8. Substrathaltevorrichtung nach einem der vorhergehenden Ansprüche, wobei das Tragglied (6) aus einem Isoliermaterial hergestellt ist.

## Revendications

1. Appareil de maintien d'un substrat pour maintenir un substrat destiné à être poli et emboutir ledit substrat contre une surface de polissage, ledit appareil de maintien de substrat comprenant :
un corps annulaire supérieur (2) pour maintenir un substrat (W) ;
un élément de support (6) ayant un élément de contact (8, 9) monté sur sa surface inférieure, ledit élément de contact étant disposé dans un espace formé par ledit substrat (W) et ledit élément de support et ayant une membrane élastique (4) mise en contact avec ledit substrat ;
une première chambre de pression (24, 25) définie dans ledit élément de contact (8, 9) ;
une deuxième chambre de pression (22, 23) définie à l'extérieur dudit élément de contact (8, 9) ;
une source de fluide (120) pour fournir indépendamment un fluide ou créer une dépression dans ladite première chambre de pression (24, 25) et ladite deuxième chambre de pression (22, 23) ; et
une bague de retenue (3) fixée ou formée d'un seul tenant avec ledit corps annulaire supérieur (2) pour maintenir une partie périphérique dudit substrat (W) ;
**caractérisé en ce que**
ledit corps annulaire supérieur (2) comprend un passage de liquide de nettoyage (51) défini à l'intérieur de celui-ci pour fournir un liquide nettoyage (Q) dans un espacement (G) défini entre une surface circonférentielle extérieure dudit substrat (W) et ladite bague de retenue (3).

2. Appareil de maintien d'un substrat selon la revendication 1, dans lequel ladite source de fluide (120) fournit un fluide à température régulée dans ladite première chambre de pression et ladite deuxième chambre de pression, respectivement.

3. Appareil de maintien d'un substrat selon la revendication 1, dans lequel une partie de communication (83, 93) pour permettre audit fluide fourni à ladite première chambre de pression (24, 25) d'entrer en contact avec une surface de contact dudit substrat est formée dans la surface inférieure de ladite membrane élastique (4) dudit élément de contact (8, 9).

4. Appareil de maintien d'un substrat selon la revendication 1, dans lequel ledit élément de contact (8, 9) comprend un élément de maintien (82, 92) pour maintenir de manière amovible ladite membrane élastique (4).

5. Appareil de maintien d'un substrat selon la revendication 4, dans lequel ledit élément de maintien (82, 92) dudit élément de contact (8, 9) est monté de manière amovible sur ledit élément de support (6).

6. Appareil de maintien d'un substrat selon l'une quelconque des revendications précédentes, dans lequel ledit élément de contact (8, 9) comprend un élément de contact central (8) disposé à un emplacement correspondant à une partie centrale dudit substrat (W), et un élément de contact extérieur (9) disposé à l'extérieur dudit élément de contact central (8).

7. Appareil de maintien d'un substrat selon la revendication 6, dans lequel ledit élément de contact extérieur (9) est monté à une position correspondant à la partie périphérique extérieure dudit substrat (W).

8. Appareil de maintien d'un substrat selon l'une quelconque des revendications précédentes, dans lequel ledit élément de support (6) est fait d'un matériau isolant.
